# EUROPÄISCHE PATENTSCHRIFT

(11) **EP 2 415 086 B1**
(45) Veröffentlichungstag und Bekanntmachung des Hinweises auf die Patenterteilung: **27.02.2019**
(21) Anmeldenummer: 09775856.9
(22) Anmeldetag: 03.04.2009
(51) Int. Cl.: H01L 33/44, H01L 33/00, H01L 33/46, H01L 33/30, H01L 33/22, H01L 25/075

(54) **VERFAHREN ZUR HERSTELLUNG EINES OPTOELEKTRONISCHEN BAUELEMENTS, OPTOELEKTRONISCHES BAUELEMENT UND BAUELEMENTANORDNUNG MIT MEHREREN OPTOELEKTRONISCHEN BAUELEMENTEN**
METHOD FOR PRODUCING AN OPTOELECTRONIC COMPONENT, OPTOELECTRONIC COMPONENT, AND COMPONENT ARRANGEMENT HAVING A PLURALITY OF OPTOELECTRONIC COMPONENTS
PROCÉDÉ DE FABRICATION D'UN COMPOSANT OPTOÉLECTRONIQUE, COMPOSANT OPTOÉLECTRONIQUE ET ENSEMBLE COMPRENANT PLUSIEURS COMPOSANTS OPTOÉLECTRONIQUES

(43) Veröffentlichungstag der Anmeldung: 08.02.2012
(73) Patentinhaber: OSRAM Opto Semiconductors GmbH, 93055 Regensburg (DE)
(72) Erfinder: HÖPPEL, Lutz, 93087 Alteglofsheim (DE)
(74) Vertreter: Epping - Hermann - Fischer
(86) Internationale Anmeldenummer: PCT/DE2009/000477
(87) Internationale Veröffentlichungsnummer: WO 2010/111986

(56) Entgegenhaltungen:
- WO-A-2005/088743
- WO-A-2009/002045
- JP-A- 10 177 974
- JP-A- 2007 281 245
- KR-A- 20070 008 759
- US-A- 5 596 231
- US-A1- 2008 283 869

## Beschreibung

Die Erfindung betrifft ein Verfahren zur Herstellung eines optoelektronischen Bauelements mit einer Halbleiterschicht, die im Betrieb eine aktive Zone erzeugt und einer Kupfer-Schicht als Trägersubstrat, die auf der Halbleiterschicht angeordnet ist. Die Erfindung betrifft ferner ein mit diesem Verfahren hergestelltes optoelektronisches Bauelement und eine Anordnung mehrerer derartiger optoelektronischer Bauelemente.

Druckschrift KR 2007/0008759 A beschreibt ein Licht emittierendes Bauelement mit einer Halbleiterschichtenfolge auf einem Kupfer-Träger. Auf laterale Seitenflächen des Kupfer-Trägers wird eine galvanische Schicht aufgebracht, die nachträglich von dem Kupfer-Träger entfernt werden kann.

Druckschrift US 5 596 231 A beschreibt ein elektrisches Bauteil, insbesondere ein IC-Chip (integrated circuit chip), auf einer Wärmesenke, die zum Beispiel Kupfer oder Kupferlegierungen aufweist, wobei die Wärmesenke bereichsweise mit einem elektrisch isolierenden Material beschichtet ist.

Es wurde beobachtet, dass bei der Herstellung von optoelektronischen Bauelementen, die ein Kupfersubstrat (das insbesondere als Wärmesenke und zur mechanischen Stabilisierung dient) umfassen, ein sehr hoher Ausschuss nicht funktionsfähiger Bauteile erzeugt wird, insbesondere wenn es sich bei den optoelektronischen Bauelementen um Leuchtdioden oder Laserdioden handelt.

Es ist daher Aufgabe der vorliegenden Erfindung, ein Verfahren anzugeben, mit dem ein geringerer Ausschuss nicht funktionsfähiger optoelektronischer Bauelemente erhalten wird.

Diese Aufgabe wird durch das Herstellungsverfahren und das Bauelement beziehungsweise die Bauelementanordnung nach den unabhängigen Ansprüchen gelöst. Unteransprüche geben weitere Ausführungsformen sowie Verfahrensvarianten an.

Ein erfindungsgemäßes Verfahren zur Herstellung eines optoelektronischen Bauelements umfasst die folgenden Verfahrensschritte: Bereitstellen eines Aufwachssubstrats mit einer darauf angeordneten Halbleiterschicht (zur Erzeugung einer im Betrieb aktiven Zone) als Verfahrensschritt A), Aufbringen von Trennstrukturen auf der Halbleiterschicht im Verfahrensschritt B) und Aufbringen einer Vielzahl von Kupfer-Schichten auf der Halbleiterschicht in den durch die Trennstrukturen begrenzten Bereichen. Als weitere Verfahrensschritte umfasst das Verfahren das Entfernen der Trennstrukturen als Verfahrensschritt D) und das Aufbringen einer Schutzschicht zumindest auf den lateralen Flächen der Kupfer-Schichten. Schließlich umfasst das Verfahren das Aufbringen eines Hilfssubstrats auf der Kupfer-Schicht in Verfahrensschritt F), das Entfernen des Aufwachssubstrats (sodass die Oberfläche der Halbleiterschicht freigelegt wird) in Verfahrensschritt G) und das Vereinzeln des Verbunds aus der Halbleiterschicht, der Kupfer-Schichten und dem Hilfssubstrats zu voneinander getrennten Bauelementen, die dann jeweils eine (im Regelfall genau eine) Kupfer-Schicht aufweisen in Verfahrensschritt H).

Es sei an dieser Stelle darauf hingewiesen, dass mit dem Begriff "Bauelement" nicht nur fertige Bauelemente, wie beispielsweise Leuchtdioden (LEDs) oder Laserdioden gemeint sind, sondern auch Substrate und/oder Halbleiterschichten, sodass beispielsweise bereits ein Verbund einer Kupfer-Schicht und einer Halbleiterschicht ein Bauelement darstellen und Bestandteil eines übergeordneten zweiten Bauelements bilden können, in dem beispielsweise zusätzlich elektrische Anschlüsse vorhanden sind. Das erfindungsgemäße optoelektronische Bauelement kann beispielsweise ein Dünnfilm-Halbleiterchip, insbesondere ein Dünnfilm-Leuchtdiodenchip sein.

Bei dem optoelektronischen Bauelement kann es sich beispielsweise um einen Dünnfilm-Leuchtdiodenchip handeln.

Ein Dünnfilm-Leuchtdiodenchip zeichnet sich durch mindestens eines der folgenden charakteristischen Merkmale aus:
- an einer zu einem Trägerelement, insbesondere dem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist ein Trägerelement auf, bei dem es sich nicht um das Aufwachssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 µm oder weniger, insbesondere im Bereich von 10 µm oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben, deren Offenbarungsgehalt insofern hiermit durch Rückbezug aufgenommen wird. Beispiele für Dünnfilm-Leuchtdiodenchips sind in den Druckschriften EP 0905797 A2 und WO 02/13281 A1 beschrieben, deren Offenbarungsgehalt insofern hiermit ebenfalls durch Rückbezug aufgenommen wird.

Der Begriff "Schicht", wie er im Rahmen dieser Erfindung verwendet wird, kann eine einzelne Schicht oder eine Schichtenfolge aus mehreren Schichten bezeichnen. Insbesondere kann die Halbleiterschicht eine Schichtenfolge mehrerer Schichten sein (z.B. eine Folge einer p-dotierten und einer n-dotierten Halbleiterschicht). Auch eine gegebenenfalls enthaltene Spiegelschicht kann aus einer Folge von zwei Schichten oder mehr Schichten bestehen. Alle anderen im Rahmen dieser Anmeldung erwähnten Schichten bestehen im Regelfall aus genau einer Schicht, sofern nicht anders angegeben.

Dass eine Schicht oder ein Element "auf" oder "über" einer anderen Schicht oder einem anderen Element angeordnet oder aufgebracht ist, kann dabei hier und im Folgenden bedeuten, dass die eine Schicht oder das eine Element unmittelbar in direktem mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht beziehungsweise zwischen dem einen und dem anderen Element angeordnet sein.

Dass eine Schicht oder ein Element "zwischen" zwei anderen Schichten oder Elementen angeordnet ist, kann hier und im Folgenden bedeuten, dass die eine Schicht oder das eine Element unmittelbar in direktem mechanischen und/oder elektrischen Kontakt oder in mittelbarem Kontakt zur einen der zwei anderen Schichten oder Elementen und in direktem mechanischen und/oder elektrischen Kontakt oder in mittelbarem Kontakt zur anderen der zwei anderen Schichten oder Elementen angeordnet ist. Dabei können bei mittelbarem Kontakt dann weitere Schichten und/oder Elemente zwischen der einen und zumindest einer der zwei anderen Schichten beziehungsweise zwischen dem einen und zumindest einem der zwei anderen Element angeordnet sein.

Unter einer "Trennstruktur" wird erfindungsgemäß ein Strukturelement verstanden, das auf einer anderen Schicht aufgebracht wird, um zu gewährleisten, dass auf dieser Schicht eine Vielzahl weiterer (voneinander getrennter) Schichten nebeneinander aufbringbar sind. Der Zweck der Trennstruktur ist daher insbesondere, voneinander getrennte, nicht miteinander in Verbindung stehende Kupfer-Schichten auf der Halbleiterschicht aufzubringen. Weiterhin wird unter einer Trennstruktur eine Struktur aus einem Material verstanden, das sobald es seinen Zweck erfüllt hat, wieder entfernbar ist (zum Beispiel chemisch), ohne dass die angrenzenden Schichten geschädigt werden.

Das erfindungsgemäße Verfahren mit den Schritten A) bis H) wird stets so durchgeführt, dass die Schritte in der angegebenen Reihenfolge durchlaufen werden. Hierbei wird zunächst ein Aufwachssubstrat bereitgestellt, auf dem meist zunächst eine n-dotierte Halbleiterschicht aufgebracht wurde und nachfolgend eine p-dotierte Halbleiterschicht aufgebracht wurde. Auf dieser (z.B. aus den vorgenannten Teilschichten zusammengesetzten) Halbleiterschicht werden nachfolgend Trennstrukturen aufgebracht, sodass nebeneinander eine Vielzahl von Kupfer-Schichten aufgebracht werden kann. In diesem Schritt erfolgt somit die Einteilung des Aufwachssubstrats mit darauf angeordneter Halbleiterschicht in Bereiche, die später (nach Vereinzelung) die einzelnen Bauelemente bilden, die dann jeweils genau eine der im Verfahrensschritt C) erzeugten Kupfer-Schichten enthalten. Nach Aufbringen der Kupfer-Schichten werden die Trennstrukturen entfernt und anschließend die lateralen Flächen der Kupfer-Schichten mit einer Schutzschicht versehen. Die Schutzschicht kann dabei die Kupfer-Schicht vollständig bedecken, meist werden aber nur die lateralen Flächen der Kupfer-Schichten bedeckt sein und die im Wesentlichen parallel zur Halbleiterschicht verlaufenden Flächen der Kupfer-Schichten nur teilweise oder gar nicht mit der Schutzschicht bedeckt sein. Allerdings ist eine vollständige Bedeckung der Kupfer-Schicht denkbar, wenn zumindest der parallel zur Halbleiterschicht verlaufende Teil der Schutzschicht eine elektrische Leitfähigkeit gewährleistet. Auch die Flächen zwischen den einzelnen Kupfer-Schichten können mit der Schutzschicht bedeckt sein (d.h. die Flächen, die zuvor durch die Trennstrukturen abgedeckt waren).

Die "lateralen" Flächen stellen dabei die Flächen dar, die nicht parallel zur Oberfläche des Aufwachssubstrats (und der Halbleiterschicht) verlaufen, sondern insbesondere darauf im Wesentlichen senkrecht stehen. Insbesondere weisen die lateralen Flächen eine Ausrichtung auf, die der der zuvor aufgebrachten Trennstrukturen entspricht; die lateralen Flächen der Kupfer-Schichten sind also insbesondere die Flächen, die zuvor mit den Trennstrukturen eine gemeinsame Grenzfläche gebildet haben.

In dem Verfahrensschritt E) nachfolgenden Verfahrensschritt F) wird ein Hilfssubstrat auf die Kupfer-Schicht aufgebracht; dies kann beispielsweise mittels eines Vergussmaterials (z.B. eines Klebstoffs), das die Gräben, die durch die zuvor aufgebrachten Trennstrukturen entstanden sind, ausfüllt, mit dem vorhandenen Schichtenverbund erfolgen; das Hilfssubstrat kann allerdings auch direkt auf der Kupfer-Schicht (beziehungsweise einer gegebenenfalls vollflächig auf der Kupfer-Schicht aufgebrachten Schutzschicht) angeordnet werden; es kann vollflächig direkt auf der Schutzschicht und gegebenenfalls der Kupfer-Schicht oder auch direkt nur auf den im Wesentlichen parallel zur Halbleiterschicht verlaufenden Oberflächenbereich der (gegebenenfalls mit einer Schutzschicht versehenen) Kupfer-Schicht angeordnet sein. In den Schritten G) und H) wird schließlich das Aufwachssubstrat entfernt (das Hilfssubstrat gewährleistet nun einen ausreichenden mechanischen Zusammenhalt) und der bis zu diesem Verfahrensschritt erhaltene Schichtenverbund kann vereinzelt werden. Die Vereinzelung erfolgt dabei im Regelfall nach Vervollständigung Prozessablaufs; diese kann durch die Definition von Mesabereichen durch Trennung des pn-Übergangs und/oder durch Anbringung von einem elektrischen Kontakt erfolgen.

Das erfindungsgemäße Verfahren bietet den Vorteil, dass mit diesem ein deutlich geringerer Anteil von nicht funktionsfähigen oder schlecht funktionsfähigen Bauteilen erhalten wird. Erfindungsgemäß wurde erkannt, dass durch das Aufbringen einer Schutzschicht auf der Kupfer-Schicht und zwar insbesondere auf den Flächen, die später nicht von einer weiteren für die Funktionsfähigkeit des Bauteils wesentlichen Schicht bedeckt sind, der Anteil von Kurzschlüssen in den erhaltenen Bauteilen deutlich vermindert werden kann und im Regelfall auch die Lebensdauer des Bauteils erhöht werden kann (Als für die Funktionsfähigkeit des optoelektronischen Bauelements wesentliche Schicht wird erfindungsgemäß eine Schicht verstanden, ohne die bei Anlegen einer Spannung an das Bauelement keine Ausbildung einer aktiven Zone erfolgt. Insbesondere sind also als wesentliche Schichten diejenigen Schichten zu verzeichnen, durch die der Transport der Ladungsträger - also der Transport der Elektronen und/oder der Löcher - erfolgt). Es wird davon ausgegangen, dass für die Kurzschlüsse daher zum einen Probleme beim Verlöten des Bauteils entstehen (etwa durch Reste von für die elektrische Anbindung erforderlichem Lot, die auf die lateralen Seiten der Kupferschicht vorhanden sind - also in Bereichen, die nicht für eine Verlötung bestimmt waren - und einen Kurzschluss verursachen). Entsprechendes gilt, wenn statt einem Lot ein Leitkleber für die elektrische Anbindung verwendet wird. Zum anderen wird davon ausgegangen, dass die Schutzschicht eine Migration von Kupfer oder Kupfer-Ionen verhindern kann. Insbesondere in bestimmten Kunststoffen wie z.B. in Thermoplasten ist (wie bei Silber-Ionen) von einer verstärkten Migration auszugehen; die Migration erfolgt dann insbesondere beim Anlegen einer Spannung (die ein elektrisches Feld erzeugt), wobei das Kupfer (beziehungsweise die Kupfer-Ionen) dann vom Kupfer-Träger zum Beispiel in Richtung eines Kunststoffgehäuses, das für das Bauelement verwendet wird, migriert. Dies kann dazu führen, dass ein leitender Pfad im Kunststoff entsteht, der zu Fehlströmen beziehungsweise zu einem elektrischen Kurzschluss führen kann. Ein thermoplastischer Kunststoff, in dem eine derartige Migration erfolgen kann, kann beispielsweise in einer Vergussmasse, die für das erfindungsgemäße optoelektronische Bauelement eingesetzt wird, enthalten sein. Die Kupfermigration kann allerdings auch schon ohne die Anwesenheit eines Kunststoffs erfolgen. Vermutlich migrieren im elektrischen Feld die Kupfer-Ionen dann auf der Oberfläche eines Teils des Bauelements. Schließlich wurde auch festgestellt, dass durch die Schutzschicht auch - abhängig von der verwendeten Halbleiterschicht (beziehungsweise den verwendeten Teilschichten) - die Lebensdauer des erfindungsgemäßen optoelektronischen Bauelements verlängert werden kann. Es wird davon ausgegangen, dass auch hierfür eine Migration von Kupfer (beziehungsweise Kupfer-Ionen) verantwortlich ist, die eine Schädigung der Halbleiterschicht verursacht.

Die erfindungsgemäß verwendete Schutzschicht kann organische und/oder anorganische Komponenten enthalten oder aus organischen oder anorganischen Komponenten bestehen.

Wenn für die Schutzschicht lediglich eine Funktionalität als "Lötstopp-Schicht" oder "Leitkleberstopp-Schicht" in Betracht kommt, so kann die Schutzschicht aus einem anorganischen Material, insbesondere einem nichtleitenden oder nur halbleitenden anorganischen Material, beispielsweise einem Metallsalz (etwa einem Metalloxid) bestehen oder dieses als Hauptbestandteil enthalten. Ferner kann für eine Lötstopp-Funktionalität auch ein organisches Material (also insbesondere ein Lötstopplack) als Schutzschicht verwendet werden. Eine derartige "Lötstopp-Schicht" oder "Leitkleberstopp-Schicht" bewirkt dann, dass das Lot bzw. der Leitkleber die Schutzschicht nicht oder nur in sehr geringem Ausmaß benetzt, sodass Kurzschlüsse unterbunden werden können.

Wenn es erforderlich ist, eine Kupfer-Migration zu verhindern (beispielsweise aufgrund der verwendeten Vergussmasse), so kommt als Schutzschicht insbesondere anorganisches Material, insbesondere ein Metall oder ein Metallsalz (insbesondere ein Metalloxid), das eine Diffusion von Kupfer beziehungsweise Kupfer-Ionen unterbindet, in Betracht. Im Ausnahmefall kann auch ein organisches Material (insbesondere ein Duroplast) die Migration von Kupfer oder Kupfer-Ionen verhindern. Im Regelfall erfolgt durch eine derartige Schutzschicht gegen Kupfer-Migration dann ein hermetischer Abschluss der Kupfer-Schicht, so dass die Migration von Kupfer oder Kupfer-Ionen durch die Schutzschicht vollständig unterbunden wird.

Ist sowohl eine Lötstopp-Funktionalität als auch die Verhinderung einer Kupfermigration beabsichtigt, so sind insbesondere Schutzschichten geeignet, die Metallsalze (insbesondere Metalloxide) enthalten oder in den meisten Fällen sogar daraus bestehen. Im Einzelfall ist allerdings - wie vorstehend beschrieben - ein Duroplast denkbar, der sowohl eine Kupfer-Migration verhindert als auch eine Lötstopp-Funktionalität besitzt.

Das erfindungsgemäße Verfahren bietet aber nicht nur den Vorteil einer mittels der aufgebrachten Schutzschicht erreichten, verbesserten Qualität der erhaltenen Bauelemente; auch durch die Abfolge der Verfahrensschritte ist es möglich, ein Bauelement herzustellen, bei dem bezüglich der konkreten Ausgestaltung des Halbleiterschichtsystems weitgehende Freiheit besteht (und hier insbesondere der von der Kupferschicht abgewandten Hauptfläche der Halbleiterschicht beziehungsweise darauf angeordneter weiterer Schichten, durch die z.B. die Strahlung eines strahlungsemittierenden, optoelektronischen Bauelements emittiert wird). So kann beispielsweise in beliebiger Art und Weise ein elektrischer Kontakt auf der Oberfläche aufgebracht werden; es können weitere Funktionsschichten aufgebracht werden und auch die dreidimensionale Gestalt der Halbleiterschicht (beziehungsweise der durch die verschiedenen Teilschichten gebildeten Schichtenfolge) erst nach Aufbringen der Kupfer-Schicht (beziehungsweise Wärmesenke) bestimmt werden. Beispielsweise ist es möglich, eine Halbleiterschicht auszubilden, deren Schnittflächen parallel zu den beiden Hauptflächen sich ausgehend von der der Kupfer-Schicht zugewandten Hauptfläche (nachfolgend auch "obere Hauptfläche" genannt) zur anderen Hauptfläche hin verkleinern (bei einer strahlungsemittierenden Vorrichtung also in Richtung der Strahlungsemission verjüngen - also eine Mesa-Struktur besitzen). Demgegenüber weisen Bauteile, bei denen die Mesa-Struktur in inverser Form vorliegt (bei denen sich also die Schnittfläche in Richtung der Kupfer-Schicht zugewandten Hauptfläche verjüngt) eine verringerte mechanische Stabilität auf, da die obere Hauptfläche spitze Winkel mit den angrenzenden Flächen ausbildet. Erfindungsgemäß wird aufgrund der positiven Mesakanten eine erhöhte Stabilität und Bruchfestigkeit erreicht. Schließlich hat das erfindungsgemäße Verfahren auch den Vorteil, dass es mit einer besonders geringen Zahl von Schritten auskommt, bei denen Oberflächenbereiche des Bauelements beim Aufbringen einer nachfolgenden Schicht z.B. mittels eines Photoresists geschützt werden müssen.

Insbesondere kann das optoelektronische Bauelement als lichtemittierende Diode (LED) oder als Laserdiode ausgebildet sein, wobei die Halbleiterschicht zumindest eine aktive Schicht mit einem aktiven Bereich aufweist, der geeignet ist, elektromagnetische Strahlung abzustrahlen.

Der Halbleiterchip kann als aktiven Bereich in der aktiven Schicht beispielsweise einen pn-Übergang, eine Doppelheterostruktur, eine Einfach-Quantentopfstruktur (SQW-Strukturen) oder eine Mehrfach-Quantentopfstruktur (MQW-Strukturen) aufweisen. Die Bezeichnung Quantentopfstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen. Die Halbleiterschichtenfolge kann neben der aktiven Schicht mit dem aktiven Bereich weitere funktionelle Schichten und funktionelle Bereiche umfassen, ausgewählt aus p- und n-dotierten Ladungsträgertransportschichten, also Elektronen- und Lochtransportschichten, p-, n- und undotierten Confinement-, Mantel- und Wellenleiterschichten, Barriereschichten, Planarisierungsschichten, Pufferschichten, Schutzschichten und Elektroden sowie Kombinationen der genannten Schichten.

Die Halbleiterschicht kann als Epitaxieschichtenfolge, also als epitaktisch gewachsene Halbleiterschichtenfolge, ausgebildet sein. Dabei kann die Halbleiterschichtenfolge insbesondere als Nitrid-Halbleitersystem ausgebildet sein. Der Begriff Nitrid-Halbleitersystem umfasst alle Nitrid-Verbindungshalbleitermaterialien. Es kann sich dabei um eine Halbleiterstruktur aus einer binären, ternären und/oder quaternären Verbindung von Elementen der III-Hauptgruppe mit einem Nitrid handeln. Beispiele für derartige Materialien sind BN, AlGaN, GaN, InAlGaN oder weitere III-V-Verbindungen. In diesem Sinne kann die Halbleiterschichtenfolge beziehungsweise der Halbleiterchip auf der Basis von InAlGaN ausgeführt sein. Unter InAlGaN-basierte Halbleiterchips und Halbleiterschichtenfolgen fallen insbesondere solche, bei denen die epitaktisch hergestellte Halbleiterschichtenfolge in der Regel eine Schichtenfolge aus unterschiedlichen Einzelschichten aufweist, die mindestens eine Einzelschicht enthält, die ein Material aus dem III-V-Verbindungshalbleitermaterialsystem InₓAl_{y}Ga_{1-x-y}N mit 0 ≤ x ≤ 1, 0 ≤ y ≤ 1 und x + y ≤ 1 aufweist. Halbleiterschichtenfolgen, die zumindest eine aktive Schicht auf Basis auf InGaAlN aufweisen, können beispielsweise elektromagnetische Strahlung in einem ultravioletten bis grünen oder grün-gelben Wellenlängenbereich emittieren.

Weiterhin kann die Halbleiterschichtenfolge beispielsweise auf der Basis von AlGaAs ausgeführt sein. Unter AlGaAsbasierten Halbleiterchips und Halbleiterschichtenfolgen fallen insbesondere solche, bei denen die epitaktisch hergestellte Halbleiterschichtenfolge in der Regel eine Schichtenfolge aus unterschiedlichen Einzelschichten aufweist, die mindestens eine Einzelschicht enthält, die ein Material aus dem III-V-Verbindungshalbleitermaterialsystem AlₓGa₁₋ₓAs mit 0 ≤ x ≤ 1 aufweist. Insbesondere kann eine aktive Schicht, die ein auf AlGaAs basierendes Material aufweist, geeignet sein, elektromagnetische Strahlung mit einer oder mehreren spektralen Komponenten in einem roten bis infraroten Wellenlängenbereich zu emittieren. Weiterhin kann ein derartiges Material zusätzlich oder alternativ zu den genannten Elementen In und/oder P aufweisen.

Alternativ oder zusätzlich kann die Halbleiterschichtenfolge oder der Halbleiterchip neben oder anstelle der III-V-Verbindungshalbleitermaterialsysteme auch II-VI-Verbindungshalbleitermaterialsysteme aufweisen.

Alle vorab angegebenen Materialien können einen oder mehrere Dotierstoffe aufweisen sowie zusätzliche Bestandteile, die die physikalischen Eigenschaften des Materials im Wesentlichen nicht ändern.

Die in Schritt C) des erfindungsgemäßen Verfahrens aufgebrachte Kupfer-Schicht kann mittels jeglichen Verfahrens zur Aufbringen von Metallschichten aufgebracht werden. Insbesondere ist aus wirtschaftlichen Gründen das Aufbringen mittels eines galvanischen Verfahrens (insbesondere mittels stromloser Abscheidung oder mittels anodischer Oxidation) sinnvoll. Beispielsweise kann diese erfindungsgemäß aufgrund der Trennstrukturen in Form einer "geslotteten galvanischen Abscheidung" erfolgen. Selbstverständlich sind aber auch andere Verfahren zur Abscheidung der Kupfer-Schicht möglich.

Die erfindungsgemäße Kupfer-Schicht muss keine reine Kupfer-Schicht sein, sondern kann auch Zusätze enthalten, mit denen eine erhöhte Steifigkeit, eine Porosität oder eine erhöhte Spannung realisiert werden kann. Im Regelfall werden nicht mehr als 1 Gew.-% Zusätze enthalten sein, meist nicht mehr als 0,5 Gew.-%. Als Zusätze sind zum einen Nickelzusätze zu nennen (die beispielsweise als Interlayer eine bessere Härte der Kupfer-Schicht - und damit eine erhöhte mechanische Belastbarkeit - verursachen, aber einen höheren Gewichtsanteil als vorstehend angegeben erfordern und bei Anwendung eines galvanischen Verfahrens zum Beispiel mittels eines Wechsels des Galvanikbads erzeugt werden müssen), zum anderen nichtmetallische Zusätze, wie beispielsweise Kohlenstoff, Schwefel oder Phosphor (die auch mittels eines galvanischen Verfahrens aus den dem Fachmann bekannten Zusätzen in die Kupfer-Schicht eingebaut werden, wobei die Einbaurate im Regelfall über die gewählte Stromdichte und Temperatur beeinflussbar ist).

In einer Ausführungsform des erfindungsgemäßen Verfahrens weist die Halbleiterschicht auf ihrer dem Aufwachssubstrat abgewandten Seite (nachfolgend auch "untere Hauptfläche" genannt) eine reflektierende Schicht (insbesondere eine Spiegelschicht) auf, mittels derer im optoelektronischen Bauelement erzeugte Strahlung in Richtung der Strahlungsaustrittsfläche umgelenkt werden kann. Für die Spiegelschicht kann ein Material verwendet werden, welches als Hauptbestandteil Silber umfasst. Die Spiegelschicht kann auf die Halbleiterschicht beispielsweise durch Aufdampfen, Sputtern oder CVD aufgebracht werden. Die Spiegelschicht kann auch durch einen weiteren Verfahrensschritt strukturiert werden, ohne dass dabei die Halbleiterschicht strukturiert wird (zum Beispiel durch nasschemisches Ätzen oder Plasmaätzen). Eine strukturierte Spiegelschicht hat den Vorteil, dass bei Betrieb des Bauelements an den Stellen, an denen die Spiegelschicht entfernt wurde, die Stromeinprägung reduziert oder ganz verhindert wird. Somit kann gezielt die Stromeinprägung an den Stellen, wo an der gegenüberliegenden Seite der Halbleiterschicht, der Auskoppelseite, Abschattungen, wie Leiterbahnen oder Bondpads, liegen, unterbunden werden.

Weiterhin kann eine Diffusionsbarriereschicht auf der Spiegelschicht aufgebracht sein, die eine Diffusion von Silber beziehungsweise Silber-Ionen, die in der Spiegelschicht enthalten sind, verhindert. Eine derartige Diffusionsbarriereschicht kann beispielsweise aus einem Material bestehen, das TiWN und/oder TiN umfasst und kann beispielsweise mittels Sputtern, Aufdampfen oder CVD aufgebracht werden.

In einer weiteren Ausführungsform wird nach Schritt A) - häufig direkt nach Schritt A), aber gegebenenfalls auch nach Schritt B) - eine Kontaktschicht auf die Halbleiterschicht aufgebracht. Mit einer derartigen Kontaktschicht kann einerseits erreicht werden, dass die Kupfer-Schicht auf der Halbleiterschicht (und gegebenenfalls darauf angeordneten Spiegelschichten) besser haftet. Andererseits kann eine Kontaktschicht auch gewährleisten, dass eine verbesserte Abscheidung Kupfer-Schicht (insbesondere bei Abscheidung mittels Galvanik) erfolgt. Idealerweise vereint die Kontaktschicht beide Anforderungen. Insbesondere sind als Kontaktschicht Schichten geeignet, die Gold, Palladium, Zinn, Silber, Nickel oder Platin enthalten beziehungsweise Legierungen dieser Elemente. Insbesondere sind hierbei Schichten, die aus den genannten Elementen oder den Legierungen bestehen, geeignet. Als Legierungen sind beispielsweise Goldzinnlegierungen (beispielsweise mit einem Goldanteil von etwa 65 bis 85 Gew-%) oder auch Palladium-Indiumlegierungen zu nennen. Ein Aufbringen nach Schritt B) hat den Vorteil, dass die Kontaktschicht nicht vollflächig abgeschieden wird und dann die oben genannten Funktionen erfüllen kann, aber bei der Vereinzelung der Bauelemente keine Schnittkante durch die Kontaktschicht entsteht.

Die Kontaktschicht kann beispielsweise bis zu 1 µm dick sein, häufig wird sie aber eine Dicke von 0,5 µm oder kleiner aufweisen. Für ein verbessertes galvanisches Abscheideverhalten können z.B. auch schon eine oder wenige Atomlagen (z.B. von Palladium) ausreichend sein. Die Kontaktschicht kann daher auch eine Dicke kleiner 1 nm oder z.B. auch eine Dicke zwischen 1 und 100 nm aufweisen.

Die Kontaktschicht kann beispielsweise mittels Sputtern, Aufdampfen oder CVD-Verfahren oder ähnlichem Verfahren aufgebracht werden.

In einer Ausgestaltung dieser Ausführungsform kann das Bauelement nach Schritt G) getempert werden. Durch das Tempern erfolgt vorzugsweise eine Diffusion der Kontaktschicht und der Kupfer-Schicht, sodass an der Grenzfläche zwischen Kontaktschicht und Kupfer-Schicht eine Zone "intermetallischer Verbindung" entsteht und somit die Haftung der Kupfer-Schicht auf der Kontaktschicht und auch der Halbleiterschicht verbessert wird. Das Tempern erfolgt sinnvollerweise erst nach Schritt E), da andernfalls durch den Temperprozess eine Oberflächenoxidation der Kupfer-Schicht erfolgen würde und die oberflächliche Oxidschicht dann nachfolgend entfernt werden müsste. Grundsätzlich wäre aber auch ein Tempern bereits nach Schritt C) denkbar. Das Tempern erfolgt vorzugsweise bei Temperaturen von etwa 200° C; hierdurch wird eine ausreichend Diffusionsgeschwindigkeit der Metallatome erreicht. Eine besonders gute Diffusion kann zwischen der Kupfer-Schicht und einer Kontaktschicht aus Gold beziehungsweise einer Goldlegierung verzeichnet werden.

In einer weiteren Ausführungsform des erfindungsgemäßen Verfahrens gliedert sich der Schritt E) - Aufbringen der Schutzschicht - in zwei Teilschritte E1) und E2). Als Verfahrensschritt E1) wird dabei eine Metallschicht zumindest auf den lateralen Flächen der Kupfer-Schicht aufgebracht; als Verfahrensschritt E2) erfolgt eine Oxidation zumindest der auf den lateralen Flächen der Kupfer-Schicht aufgebrachten Metallschicht zu einer Metalloxidschicht.

Mittels eines derartigen Verfahrens kann beispielsweise zunächst die gesamte freiliegende Oberfläche der Kupfer-Schicht mit einer Metallschicht beschichtet werden und nachfolgend nur die lateralen Teilflächen der Kupfer-Schicht zu einer Metalloxidschicht oxidiert werden (bzw. die Teilbereiche der Kupfer-Schicht, die im nachfolgenden Verfahren nicht mit einer für die Funktionsfähigkeit des optoelektronischen Bauelements maßgeblichen Schicht beschichtet sind).

Vor Aufbringen der Metallschicht kann es sinnvoll sein, die freiliegenden Oberflächen der Kupfer-Schicht von auf der Oberfläche gebildeten Oxiden zu befreien und beispielsweise mittels Plasmaätzens zu entfernen; alternativ kann die Entfernung mit einer geeigneten Nasschemie erfolgen. Die Oxidation in Teilschritt E2) kann beispielsweise in einem Plasmaofen erfolgen. Die dabei gebildete Metalloxidschicht muss dabei nicht ein vollständig stöchiometrisches Metalloxid bilden; es kann auch, insbesondere in den nicht oberflächennahen Bereichen, nur eine teilweise Oxidation erfolgen, sodass ein nichtstöchiometrisches Metalloxid resultiert. Statt einer Umwandlung in ein Metalloxid ist natürlich auch die Umwandlung in ein Metallnitrid oder ein Oxinitrid beziehungsweise ähnliche Substanzen denkbar.

Das Aufbringen der Metallschicht kann mittels der üblichen Beschichtungsverfahren beispielsweise mittels Sputtern, Aufdampfen, CVD oder auch mittels eines galvanischen Verfahrens erfolgen. Bei bestimmten Metallsalzen (zum Beispiel Metallnitriden) kann es allerdings sinnvoll sein, nicht das zweistufige Verfahren E1), E2) durchzuführen, sondern direkt in einem die Metallsalz-Schicht auf den lateralen Flächen der Kupfer-Schicht aufzubringen (beispielsweise mittels eines CVD-Verfahrens, bei dem entsprechende Prozessgase zugesetzt werden und entsprechende Precursor des Metallsalzes eingesetzt werden).

Wird eine Schutzschicht aus Metalloxid (oder auch einem anderen Metallsalz, wie beispielsweise einem Metallnitrid) aufgebracht, so kommen insbesondere Schichten in Betracht, die als Metall-Komponente eines oder mehrere der nachfolgenden Metalle enthalten oder bei denen die Metall-Komponente aus einem oder mehreren dieser Metalle besteht: Aluminium, Titan, Chrom, Nickel und Zink. Für eine Reihe von optoelektronischen Bauelementen hat sich (insbesondere auch aus wirtschaftlichen Aspekten) eine Schutzschicht, die aus einer Metallschicht aus Nickel erzeugt wird, als vorteilhaft erwiesen.

In einer weiteren Ausführungsform des erfindungsgemäßen Verfahrens kann nach Schritt G) der Schritt K1) erfolgen. Hierbei wird auf einem Teilbereich der Oberfläche der Halbleiterschicht (die in Schritt G) freigelegt wurde) ein elektrischer Kontakt aufgebracht werden. Prinzipiell kann Schritt K1) auch zu einem späteren Zeitpunkt erfolgen. Üblicherweise wird er aber direkt nach Schritt G) (oder gegebenenfalls direkt nach dem nachfolgend beschriebenen Schritt K2)) erfolgen.

In einer weiteren Ausführungsform erfolgt nach Schritt G) der Schritt K2). Hierbei wird die in Schritt G) freigelegte Oberfläche der Halbleiterschicht strukturiert. Das Strukturieren kann hierbei darin bestehen, dass Gräben in die Oberfläche eingebracht werden und/oder darin, dass die obere Hauptfläche der Halbleiterschicht aufgeraut wird.

Das Einbringen von Gräben in die Oberfläche kann beispielsweise mittels eines Ätzverfahrens erfolgen. Dieses wird insbesondere so durchgeführt, dass Mesagräben durch den Ätzprozess entstehen; insbesondere werden diese Mesagräben derart ausgebildet, dass die zuvor vorhandene Halbleiterschicht in einzelne Halbleiterstrukturen unterteilt wird, die dann der Halbleiterschicht des nach der Vereinzelung (Schritt H)) erhaltenen Bauelements entspricht. Im Regelfall wird die Strukturierung zu Mesagräben also derart erfolgen, dass die Mesagräben mit den in Schritt B) aufgebrachten "Gräben" zwischen den einzelnen Kupfer-Schichten räumlich korrespondieren, sodass insbesondere bei der Vereinzelung die einzelnen Bauelemente in einem Schritt voneinander getrennt werden können. Die Mesabereiche können auch aus einem Bruchteil der späteren Chipfläche bestehen, d.h. ein Chip umfasst dann mehrere separierte Halbleiterbereiche, die aber wiederum elektrisch miteinander kombiniert sein können.

Dadurch, dass das Ätzen der Mesagräben von der Seite der Oberfläche erfolgt, die im Verfahrensschritt G) freigelegt wurde, werden positive Mesakanten oder Mesakanten, die mit der Oberfläche einen Winkel von 90° ausbilden, erhalten. Das bedeutet, dass sich die Mesagräben, die durch den Ätzprozess entstanden sind, von der "Fläche", die zuvor mit dem Aufwachssubstrat verbunden war, her betrachtet zu den anderen Schichten hin verjüngen; die Mesa selbst, also insbesondere die Halbleiterschicht, verbreitert sich hingegen von der oberen Hauptfläche her betrachtet. Die Flanken der Mesagräben sind insbesondere leicht schräg und verlaufen nicht senkrecht zur Oberfläche, was die Folge eines Nass-Ätz-Verfahrens ist. Winkel von annähernd 90° können beispielsweise mittels eines Trocken-Ätz-Verfahrens erhalten werden.

Eine positive Mesakante hat nicht nur mechanische Vorteile; es sind auch gewisse Verbesserungen der Lichtabstrahlung bei einem strahlungsemittierenden Bauelement möglich.

Die Strukturierung der Oberfläche der Halbleiterschicht kann auch darin bestehen, dass die Oberfläche aufgeraut wird.

Mittels einer derart aufgerauten Oberfläche kann - im Fall eines strahlungsemittierenden Bauelements - eine verbesserte Strahlungsauskopplung erreicht werden. Das Aufrauen der Oberfläche kann ebenfalls mittels eines Ätzprozesses erfolgen.

Die der Erfindung zugrundeliegende Aufgabe löst auch das optoelektronische Bauelement sowie eine Bauelementanordnung mit mehreren derartigen optoelektronischen Bauelementen.

Gemäß einer Ausführungsform umfasst das optoelektronische Bauelement eine Halbleiterschicht, die auf einer Kupfer-Schicht als Trägersubstrat angeordnet ist. Zumindest auf den lateralen Flächen der Kupfer-Schicht ist dabei eine Schutzschicht angeordnet.

Beim Betrieb des optoelektronischen Bauelements kommt es in der Halbleiterschicht zur Ausbildung einer aktiven Zone, insbesondere zur Emission von Strahlung. Durch die auf den lateralen Flächen der Kupfer-Schicht angeordnete Schutzschicht können Kurzschlüsse verhindert werden und/oder die Lebensdauer des Bauelements verlängert werden. Insbesondere ist davon auszugehen, dass die Schutzschicht eine Migration von Kupfer beziehungsweise Kupfer-Ionen verhindert und/oder als Lötstopp-Funktionalität beziehungsweise als Leitkleberstopp-Schicht dient.

In einer Ausführungsform enthält die Schutzschicht Nickel, insbesondere in Form von Nickeloxid.

In einer weiteren Ausführungsform umfasst die Halbleiterschicht eine AlGaInP-Schicht und/oder eine AlGaInAs-Schicht. Wie oben erwähnt, kann die Halbleiterschicht aus mehreren Teilschichten bestehen und eine oder beide der vorgenannten Schichten eine dieser Teilschichten sein. Erfindungsgemäß wird unter einer AlGaInP- oder AlGaInAs-Schicht eine Schicht verstanden, die auf AlGaInP beziehungsweise AlGaInAs basiert. Erfindungsgemäß ist eine derartige Schicht also folgendermaßen definiert: Die Schicht umfasst mindestens ein Material AlₓGa_{y}In_{1-x-y}P oder AlₓGa_{y}In_{1-x-y}As mit 0 ≤ x ≤ 1, 0 ≤ y ≤ 1 und x+y ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Bauelemente mit derartigen Schichten können z.B. grünes bis rotes Licht emittieren, insbesondere rotes, gelbes oder oranges Licht.

Erfindungsgemäß wurde beobachtet, dass optoelektronische Bauelemente, die eine AlGaInP- beziehungsweise eine AlGaInAs-Schicht enthalten, einen besonders hohen Ausschuss nicht oder schlecht funktionsfähiger Bauteile liefern, sofern nicht die erfindungsgemäß vorgesehene Schutzschicht enthalten ist. Es wird daher davon ausgegangen, dass diese Schichten durch eine Kupfer-Migration besonders leicht beschädigt werden können, was letztlich dazu führt, dass die Halbleiterschicht nicht mehr ihre Funktion erfüllen kann und beispielsweise die LED nicht mehr oder nur noch mit schwächerer Leistung leuchtet.

In weiteren Ausführungsformen weist das optoelektronische Bauelement direkt auf der Halbleiterschicht zugewandten Hauptfläche der Kupfer-Schicht eine Kontaktschicht, insbesondere eine Kontaktschicht aus Gold, Palladium, Platin oder einer Legierung dieser Elemente auf; unabhängig davon kann das Bauelement auf der der Kupfer-Schicht zugewandten Seite der Halbleiterschicht eine Spiegelschicht aufweisen. Üblicherweise ist diese dann direkt auf der Halbleiterschicht angeordnet. Gegebenenfalls ist auf der der Kupfer-Schicht zugewandten Seite der Spiegelschicht eine Diffusionsbarriereschicht angeordnet.

Die erfindungsgemäße Aufgabe wird schließlich auch durch eine Bauelementanordnung mit mehreren optoelektronischen Bauelementen, die in mechanischem Verbund zueinander stehen (also stoff-, kraft- oder formschlüssig miteinander verbunden sind) gelöst. Insbesondere sind die optoelektronischen Bauelemente in einem gemeinsamen Gehäuse angeordnet, sodass grundsätzlich ein Diffusionsweg für Ionen (zum Beispiel Silber oder Kupfer-Ionen)zwischen den einzelnen optoelektronischen Bauelementen der Bauelementanordnung zur Verfügung steht. Die Bauelemente können insbesondere auf einem gemeinsamen Trägermaterial angeordnet sein, das vorzugsweise zusammen mit dem Gehäuse die Anordnung aus Halbleiterschicht und Kupferschicht vollständig umschließt. Ferner können die einzelnen Bauelemente über eine Vergussmasse miteinander verbunden sein. Eine derartige Bauelementanordnung ist weiterhin dadurch charakterisiert, dass die einzelnen optoelektronischen Bauelemente gleich oder verschieden sein können (zum Beispiel Licht in verschiedenen Farben emittieren können), wobei beispielsweise eines der in der Bauelementanordnung enthaltenen Bauelemente eine Halbleiterschicht aufweisen kann, die eine AlGaInP- und/oder eine AlGaInAs-Schicht umfasst.

Mittels einer derartigen Bauelementanordnung ist es möglich, die Lebensdauer der besonders empfindlichen Bauelemente mit AlGaInP- oder AlGaInAs-Schicht zu verlängern und somit die Lebensdauer der Bauelementanordnung insgesamt deutlich zu verlängern. Durch die erfindungsgemäß vorgesehenen Schutzschichten wird offenbar eine Diffusion von Kupfer oder Kupfer-Ionen aus einem ersten optoelektronischen Bauelement dieser Bauelementanordnung in ein zweites, eine AlGaInP und/oder AlGaInAs umfassendes optoelektronisches Bauelement zu verhindern.

Häufig weist auch das erfindungsgemäße (einzelne) Bauelement die vorher beschriebene Anordnung aus Trägersubstrat und Gehäuse auf; hierbei muss das optoelektronische Bauelement selbst nicht unbedingt das einzige Funktionselement in dem Gehäuse sein - es können auch andere Funktionselemente (zum Beispiel Funktionselemente die den Betriebszustand des Bauelements registrieren und dieses stetig steuern, Temperatursensoren und/oder Lichtsensoren) enthalten sein.

Im Folgenden sollen Varianten der Erfindung anhand von Figuren und Ausführungsbeispielen näher erläutert werden.

Es zeigen:
- Figur 1: eine Schichtenfolge aus einem Aufwachssubstrat und einer Halbleiterschicht mit darauf angeordneter Spiegelschicht.
- Figur 2: die Schichtenfolge aus Figur 1, auf der zusätzlich eine Diffusionsbarriereschicht und eine Kontaktschicht aufgebracht sind.
- Figur 3: eine Schichtenfolge gemäß Figur 2, bei der zusätzlich Trennstrukturen aufgebracht sind.
- Figur 4: den Schichtverbund von Figur 3 mit zwischen den Trennstrukturen angeordneten Kupferschichten.
- Figur 5: den Schichtverbund nach Entfernung der Trennstrukturen.
- Figur 6: den Schichtverbund gemäß Figur 5 nach Aufbringen der Metallschicht.
- Figur 7: den Schichtverbund nach dem Tempern.
- Figur 8: den Schichtverbund gemäß Figur 7, bei dem ein Rückseitenkontakt aufgebracht ist.
- Figur 9: den Zustand des Schichtverbunds nach Oxidation der Schutzschicht auf den lateralen Flächen der Kupferschicht.
- Figur 10: die Schichtenfolge gemäß Figur 9 mit aufgebrachtem Hilfssubstrat.
- Figur 11: zeigt die Schichtenfolge nach Entfernen des Aufwachssubstrats.
- Figur 12: zeigt die Schichtenfolge mit kontaktierter Oberfläche.
- Figur 13: zeigt die Schichtenfolge mit aufgerauter Halbleiterschicht.
- Figur 14: zeigt die Schichtenfolge mit Mesagraben.
- Figur 15: zeigt die Schichtenfolge mit Deckschicht.
- Figur 16: zeigt die Schichtenfolge nach Überführung auf ein elastisches Substrat.
- Figur 17: zeigt die schematische Ansicht vereinzelter Bauelemente auf einem elastischen Substrat.
- Figur 18: zeigt eine schematische Ansicht eines vereinzelten Bauelements auf einer Leiterplatte.
- Figur 19A: und B zeigt eine schematische Ansicht einer Bauelementanordnung mit drei optoelektronischen Bauelementen auf einem gemeinsamen Träger in der Seitenansicht und in der Draufsicht.

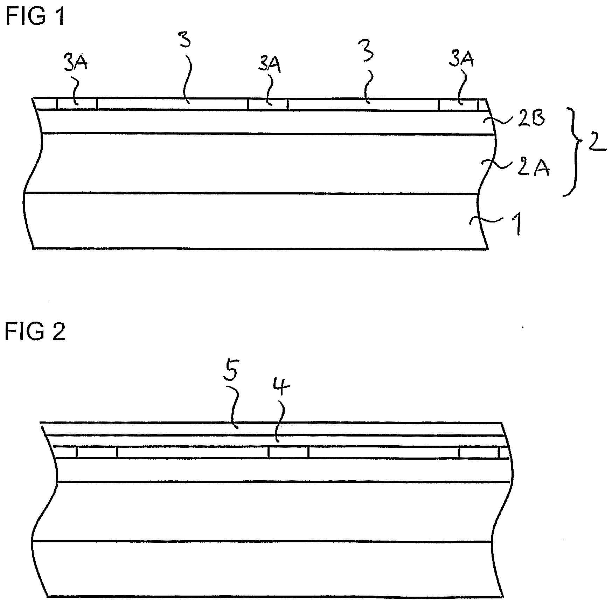

Figur 1 zeigt eine schematische Seitenansicht der in Verfahrensschritt A) bereitgestellten Schichtenfolge. Diese umfasst drei Schichten (wobei sich die Halbleiterschicht 2 in zwei Teilschichten unterteilt ist) mit der Schichtenfolge Aufwachssubstrat 1, n-dotierte Halbleiterschicht 2a (zum Bespiel n-dotierte Galliumnitridschicht), p-dotierte Halbleiterschicht 2b (zum Beispiel p-dotierte Galliumnitridschicht), Spiegelschicht 3. Die Spiegelschicht kann hierbei durch Diffusionsbarriere-Bereiche 3a unterbrochen sein (die zum Beispiel aus SiO₂ bestehen können).

Als Aufwachssubstrat kommt ein Substrat aus GaP, GaN, SiC, Si, Ge oder auch aus Saphir in Betracht. Häufig wird ein Substrat aus Saphir oder Silizium eingesetzt werden.
Figur 2 zeigt eine Seitenansicht nach Aufbringen einer Diffusionsbarriereschicht 4 (die insbesondere die Migration von Silber-Ionen der Spiegelschicht verhindern soll) und einer Kontaktschicht 5 (die insbesondere als Seed-Layer für die nachfolgend aufzubringende Kupfer-Schicht dient). Die Kontaktschicht 5 kann beispielsweise aus Gold oder einer Gold-Zinn-Legierung bestehen.
Die Diffusionsbarriereschicht 4 kann beispielsweise aus Nickel bestehen. Um einen ohmschen Anschluss an die nachfolgenden Schichten zu gewährleisten, ist es daher häufig sinnvoll eine Ionenvorreinigung durchzuführen, bei der auf der Oberfläche einer derartigen Nickelschicht (oder einer anderen Metallschicht, die als Diffusionsbarriereschicht verwendet wird) das natürliche Oxid des jeweiligen Metalls zu entfernen. Dieser Schritt kann in situ vor Aufbringen der Kontaktschicht 5 erfolgen.

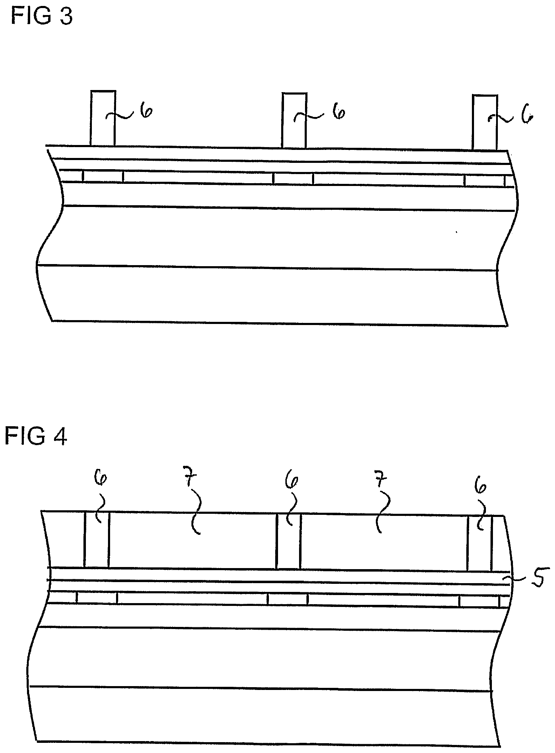

Figur 3 zeigt eine schematische Seitenansicht einer Ausführungsform, wie sie aus Figur 2 hervorgehen könnte. Hierbei wurden auf die Kontaktschicht 5 Trennstrukturen 6 aufgebracht. Die Trennstrukturen 6 sind insbesondere dazu vorgesehen, die Kupfer-Schichten für die einzelnen optoelektronischen Bauelemente voneinander zu separieren; ihre Lage korrespondiert mit den Diffusionsbarriere-Bereichen 3a.
Die Trennstrukturen sind erfindungsgemäß insbesondere aus einem Material ausgebildet, das verhindert, dass bei einem galvanischen Abscheideverfahren auf der Oberfläche dieses Trennstruktur-Materials eine metallische Schicht abgeschieden wird. Die Trennstrukturen bewirken daher, dass die metallische Schicht nur zwischen den vertikalen Seiten der Trennstruktur auf der jeweiligen horizontal zwischen diesen Trennstrukturen angeordneten Fläche (im vorliegenden Fall der Kontaktschicht 5) abgeschieden wird. Die Trennstruktur kann insbesondere aus einem nicht leitfähigen Material bestehen und kann fotosensitiv oder nicht-fotosensitiv sein. Geeignete Materialien für eine derartige Trennstruktur umfassen Polymere, Polyimide, Epoxy-Harze, Photolacke, thermoplastische Verbindungen, Parylen und ähnliche Materialen.

Figur 4 zeigt eine schematische Seitenansicht, bei der zwischen die in Figur 3 gezeigten Trennstrukturen eine Kupfer-Schicht 7 eingebracht wurde. Die Kupfer-Schicht 7 kann insbesondere mittels Galvanisierung aufgebracht werden, wobei die Kontaktschicht 5 eine beschleunigte Abscheidung begünstigt und als Seed-Layer wirkt.

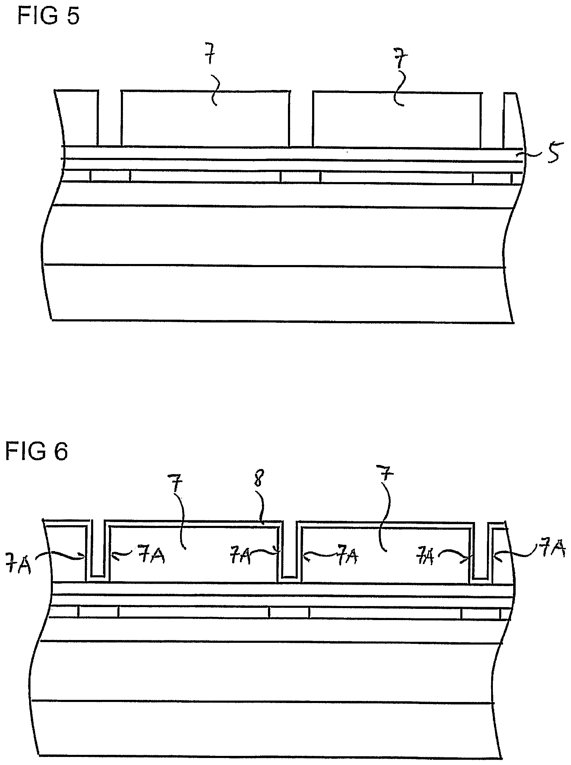

Figur 5 zeigt eine schematische Seitenansicht einer Ausführungsform einer Schichtenanordnung, bei der die Trennstrukturen 6, die in Figur 4 gezeigt sind wieder entfernt wurden. Zwischen den Kupfer-Schichten 7 sind daher Gräben ausgebildet, durch die die Schnittebene bei einer nachfolgenden Vereinzelung verlaufen wird. Die Gräben korrespondieren daher mit den Diffusionsbarriere-Bereichen 3a.

Figur 6 zeigt eine schematische Seitenansicht einer Ausführungsform, bei der auf der Schichtanordnung gemäß Figur 5 eine Metallschicht 8 abgeschieden wurde. Das Schichtabscheideverfahren wird dabei so durchgeführt, dass auch die lateralen Flächen 7a der Kupfer-Schicht 7 vollständig mit der Metallschicht 8 bedeckt sind.

Die Dicke der Metallschicht 8 beträgt hierbei meist 1 bis 6 µm, häufig wird eine Schichtdicke von 2 bis 3 zum Beispiel 3 µm gewählt sein. Allerdings können auch Schichtdicken von 200 nm bereits den mit der aus der Metallschicht hergestellten Schutzschicht 11 beabsichtigten Zweck erfüllen. Schichtdicken größer 6 µm sind aus produktionstechnischen Gründen häufig schlechter geeignet.

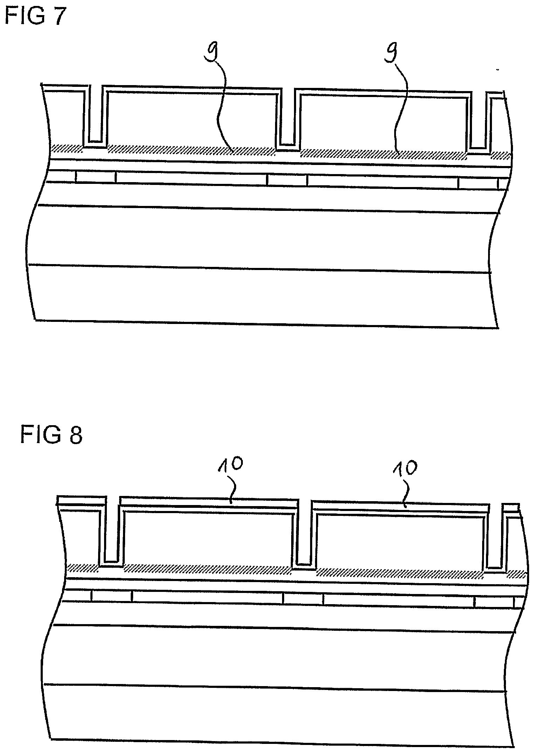

Figur 7 zeigt eine schematische Seitenansicht einer Ausführungsform einer Schichtanordnung gemäß Figur 6, bei der das Schichtsystem getempert wurde, sodass eine Diffusion zwischen Kupfer-Schicht 7 und Kontaktschicht 5 erfolgt. Besteht beispielsweise die Kontaktschicht aus Gold oder aus einer Goldlegierung, erfolgt an der Grenzfläche eine "Durchmischung" von Gold und Kupfer und es erfolgt eine intermetallische Verbindung (bei der allerdings eine statistische Verteilung der verschiedenen Atomsorten vorliegt und keine echte Legierung im Sinne einer chemischen Verbindung mit einem definierten Schmelzpunkt entsteht). Durch das Tempern wird eine "Diffusionsschicht" 9 erhalten, die zu einer verbesserten Haftung der Kupfer-Schicht auf der Goldschicht führt. Das Tempern kann beispielsweise bei einer Temperatur von 100 bis 200° C, häufig 180 bis 200° C für eine Zeit von 30 Minuten bis 1 Stunde durchgeführt werden.

Figur 8 zeigt eine schematische Seitenansicht der Schichtanordnung gemäß Figur 7, bei der ein Rückseitenkontakt 10 aufgebracht wurde. Der Rückseitenkontakt kann hierbei beispielsweise aus einem elektrisch leitfähigen Edelmetall und/oder insbesondere Materialien, die für einen Lötprozess des Chips auf eine Kontaktfläche geeignet sind. Zu nennen sind beispielsweise Materialien, die aus Gold, Silber, Zinn, Nickel und/oder Legierungen dieser Metalle bestehen oder die vorgenannten Metalle und/oder Legierungen als Hauptbestandteil enthalten. Wie bereits bezüglich der Diffusionsbarriereschicht 4 und der Kontaktschicht 5 beschrieben, kann hierbei zur besseren Haftung die Oberfläche der Metallschicht 8 einer Ionenvorreinigung unterzogen werden, um gebildetes Oberflächenoxid zu entfernen.

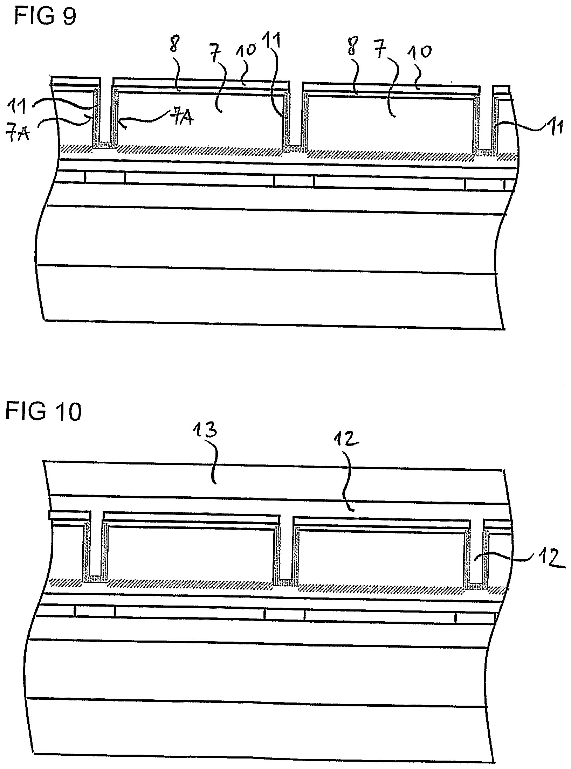

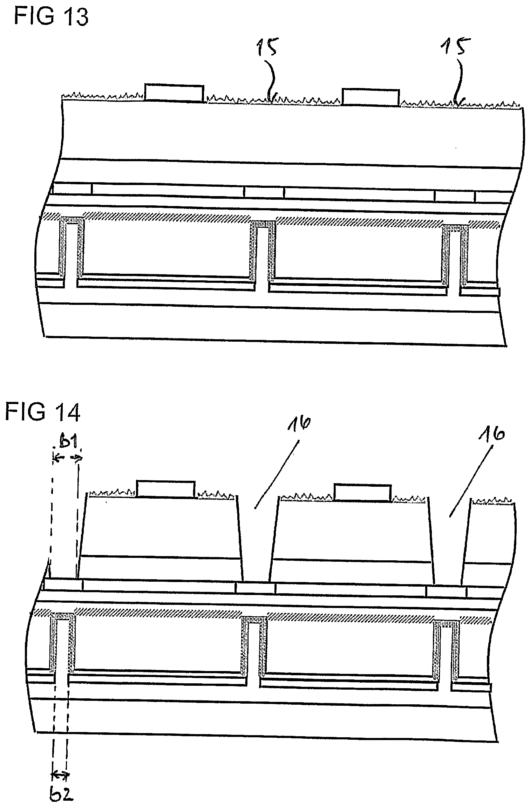

Die in Figur 9 gezeigte schematische Seitenansicht der Schichtanordnung zeigt den Zustand nach Durchführung des Verfahrensschritts E) beziehungsweise E2). Hierbei wurden die auf den lateralen Seitenflächen 7a der Kupfer-Schicht 7 angeordnete Metallschicht 8 zu einer Schutzschicht 11 aus Metalloxid oxidiert. Die Oxidation kann beispielsweise in einem Plasmaofen erfolgen. Um eine Oxidation der auf horizontalen Flächen der Kupfer-Schicht angeordneten Metallschicht 8 zu verhindern, kann statt der in Figur 8 gezeigten Rückseitenkontakt-Schicht auch eine beliebige weitere Schutzschicht aufgebracht werden, insbesondere eine Schicht, die sich nur auf die zu schützende Fläche aufbringen lässt. Hierzu kann man die hohe Direktionalität eines Aufdampfprozesses ausnützen.
Figur 10 zeigt eine schematische Seitenansicht einer Schichtanordnung, bei der ein Hilfssubstrat 13 aufgebracht wurde. Hierbei wird das Hilfssubstrat 13 mittels eines Klebstoffs 12, der auch die Zwischenräume zwischen den Metallschichten 7 (die durch die Trennstrukturen 6 hervorgerufen wurden) ausfüllen kann, auf der Schichtanordnung befestigt. Das Hilfssubstrat hat häufig eine Dicke zwischen 5 µm und 1000 µm. Es ist jegliches Material geeignet, also auch elektrisch leitfähiges Material, wie Metalle oder Nichtleiter, wie beispielsweise Saphir. Das Hilfssubstrat dient dazu, die Schichtenfolge zu stabilisieren, um eine Entfernung des Aufwachssubstrats zu ermöglichen.

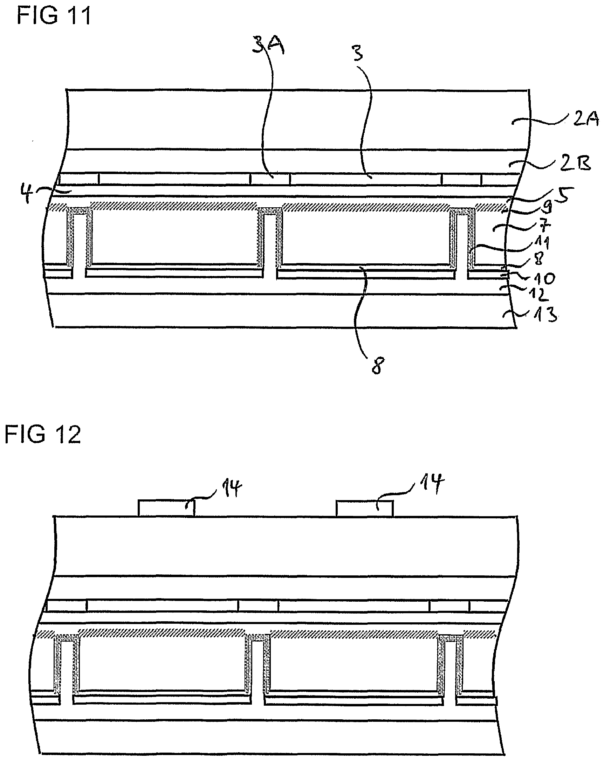

Figur 11 zeigt eine schematische Seitenansicht einer Ausführungsform der Schichtanordnung gemäß Figur 10 (die um 180° gedreht wurde) nach Entfernen des Aufwachssubstrats 1. Das Aufwachssubstrat kann hierbei beispielsweise mittels Laser-Lift-Off (LLO) entfernt werden.
Beim Laser-Lift-Off (LLO) wird das Substrat, welches von den anderen Schichten abgelöst werden soll, mit einem gepulsten oder nicht gepulsten Laser bestrahlt, welcher das Substrat durchdringt. Dadurch kommt es zur Erwärmung der Oberfläche der Halbleiterschicht, welche an das Substrat anschließt. Ist die nötige Temperatur erreicht kommt es zur Abspaltung des Substrates. Ein Trennverfahren von Substrat und Halbleiterschicht mittels Laser-Lift-Off ist beispielsweise in der DE 19640594 A1 erläutert. Im Falle von Silizium als Wachstumssubstrat kann beispielsweise auch ein überwiegend chemisches Abtragsverfahren zum Einsatz kommen, welches selektiv auf den Halbleiterschichten stoppt.
Nach dem Abheben des Aufwachssubstrats 1 wird die dadurch freigelegte Seite der Halbleiterschicht 2 fertig prozessiert. Hierbei können beispielsweise elektrische Kontaktstrukturen 14 (zum Beispiel Bondpads) aufgebracht werden. Dies entspricht dem Verfahrensschritt K1) beziehungsweise Figur 12. In Figur 13 ist eine schematische Seitenansicht der Schichtanordnung gezeigt, bei der die freigelegte Seite der Halbleiterschicht 2 aufgeraut wurde (beispielsweise mittels Kaliumhydroxid) sodass eine unregelmäßige Oberfläche 15 der Halbleiterschicht entsteht, die eine verbesserte Strahlungsauskopplung gewährleistet.
Figur 14 zeigt den Zustand des Schichtsystems nach Strukturierung der Oberfläche 15 der Halbleiterschicht 2; dies kann beispielsweise mittels Maskieren und Ätzen erfolgen. Hierbei werden eine Vielzahl von Gräben 16 (beziehungsweise Mesen) erhalten und die vorher durchgängige Halbleiterschicht 2 in einzelne Schichten (beziehungsweise Teilschichtenstapel) unterteilt. Die räumliche Anordnung der Gräben 16 korrespondiert hierbei mit der Anordnung der durch die Trennstrukturen 6 erzeugten Zwischenräume zwischen den Kupferschichten 7. Die Gräben 16 verjüngen sich hierbei in Richtung der Kupferschicht; hierdurch werden positive Mesakanten - wie in Figur 14 gezeigt - erhalten.
In einer Ausführungsform ist die Breite b1 des Grabens 16 größer als die des zwischen den einzelnen Kupfer-Schichten vorhandenen "Grabens" b2. Hierdurch wird ein Bauelement erhalten, bei dem die Breite der Kupfer-Schicht größer ist als die der Halbleiterschicht. Dies führt zu einer zusätzlichen mechanischen Stabilisierung des Bauelements. Die Breite b1 beträgt dabei im Regelfall mindestens 22 µm; die Breite b2 ist üblicherweise zumindest 30 µm. Häufig liegt die Breite b1 zwischen 40 und 50 µm, zum Beispiel 43 und 47 µm und die Breite b2 zwischen 30 und 40 µm, häufig zwischen 33 und 37 µm. Durch derartige Breiten b1 und b2 wird gewährleistet, dass in einem späteren Vereinzelungsprozess die verschiedenen Schichten und Schutzschichten des Halbleiterbauelements nicht beschädigt werden.

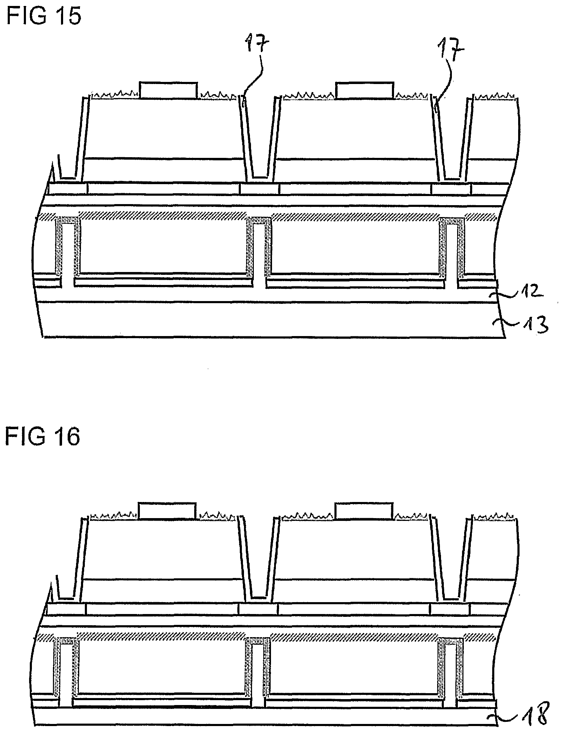

Figur 15 zeigt eine schematische Seitenansicht einer weiteren Ausführungsform. Hierbei wurden die Oberflächen der Gräben 16 mit einer Deckschicht 17 versehen. Die Deckschicht 17 dient hierbei zur Passivierung und zum Schutz der Halbleiterschicht 2 und wurde so aufgetragen, dass die elektrischen Kontaktstrukturen 14 noch frei sind, sodass eine elektrische Kontaktierung möglich ist.

Figur 16 zeigt den Zustand nach Entfernung des Hilfssubstrats 13 und einer gegebenenfalls enthaltenen Klebstoffschicht 12. Das Hilfssubstrat wurde hierbei durch ein elastisches Substrat 18 ersetzt, das es nach Durchführung des Vereinzelungs-Schritts erlaubt, dass das elastische Substrat gedehnt wird und somit eine bessere Weiterbearbeitung der vereinzelten optoelektronischen Bauelemente möglich ist.

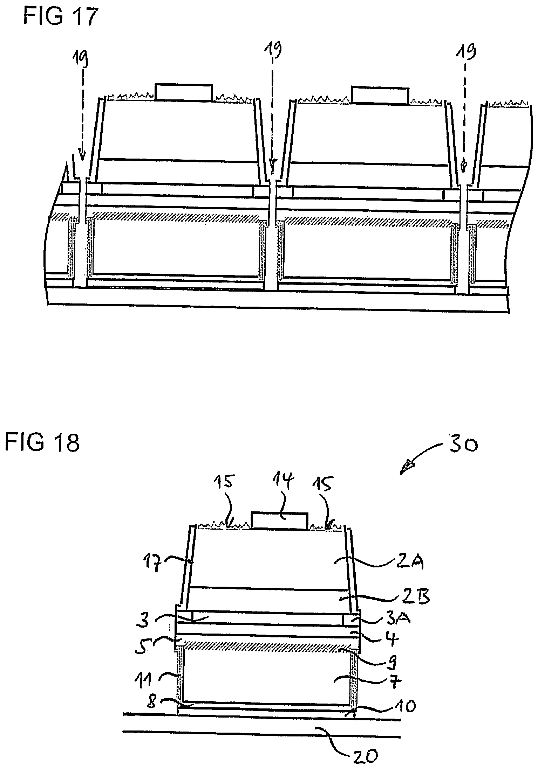

Figur 17 zeigt eine schematische Seitenansicht einer Ausführungsform nach Durchführung des Verfahrensschritts H). Hierbei wurden die optoelektronischen Bauelemente mittels eines Trennverfahrens in Richtung des Pfeils 19 voneinander getrennt. Die Vereinzelung kann hierbei beispielsweise mittels Sägen (also mechanisch) erfolgen oder mittels eines Lasers. Die Verwendung eines Lasers hat den Vorteil, dass die gebildete Schnittfuge nur etwa 9 µm breit sein kann, sodass ein besonders optimiertes Verfahren resultiert. Zudem ist das Schneiden mittels Laser besonders präzise.

Figur 18 zeigt eine schematische Seitenansicht einer Ausführungsform des erfindungsgemäßen optoelektronischen Bauelements 30, das auf einer Leiterplatte 20 angeordnet ist. Figur 18 weist ausgehend von der Leiterplatte 20 folgende Schichtenstruktur auf: Rückseitenkontaktschicht 10, Metallschicht 8, Kupfer-Schicht 7 mit auf den Seitenflächen 7a angeordneter Schutzschicht 11, Diffusionsschicht 9, Kontaktschicht 5, Diffusionsbarriereschicht 4, Spiegelschicht 3 mit seitlich angeordneten Diffusionsbarriere-Bereichen 3a, Halbleiterschicht 2 (mit den Teilschichten 2a und 2b) und der seitlich angeordneten Deckschicht 17, elektrische Kontaktstruktur 14.

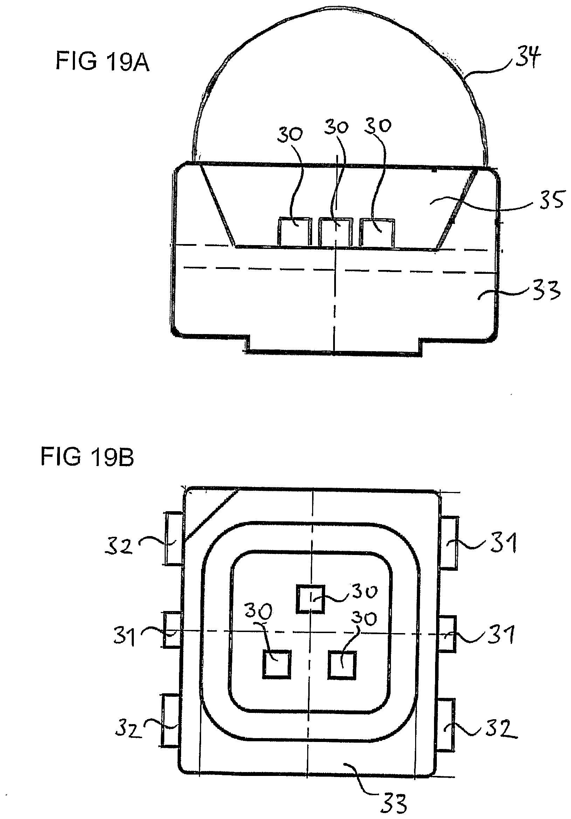

Die Figuren 19A und 19B zeigen eine schematische Ansicht einer Bauelementanordnung mit drei optoelektronischen Bauelementen 30 in der Seitenansicht (Figur 19A) und in der Draufsicht (Figur 19B).

Figur 19A zeigt eine Anordnung mit einem Trägerelement 33, bei dem die optoelektronischen Bauelemente (hier LEDs) 30 in einer Reflektorkavität 35 als Trägerelement 33 angeordnet sind. Die Reflektorkavität kann hierbei mit einer Vergussmasse aufgefüllt sein und/oder eine Strahlung reflektierende Oberfläche aufweisen. Weiterhin weist das Bauelement ein transparentes Gehäuse 34 auf. Die elektrische Kontaktierung LEDs kann mittels eines hier nicht gezeigten Bonddrahts erfolgen; allerdings kann auch eine Kontaktierung von der Unterseite des LED-Chips hier erfolgen, sodass kein Bonddraht benötigt wird. Die drei Leuchtdioden 30 können beispielsweise in drei verschiedenen Farben Licht emittieren (etwa blau, grün und gelb-orange).

Figur 19B zeigt die Ausführungsform gemäß Figur 19A in der Draufsicht. Hierbei sieht man die Anordnung der drei Leuchtdioden 30 in der Reflektorkavität 35 sowie die elektrischen Anschlüsse (Anoden 31 und Kathoden 32) die eine getrennte Ansteuerung der verschiedenen Leuchtdioden ermöglichen.

Ein optoelektronisches Bauelement in Form einer einzelnen LED kann entsprechend den Figuren 19A und 19B ausgebildet sein, wobei nur zwei elektrische Anschlüsse (und ein optoelektronisches Bauelement 30) nötig sind.

Die Erfindung ist nicht durch die Beschreibung anhand der Ausführungsbeispiele beschränkt. Der Schutzbereich wird durch die Ansprüche definiert.

## Patentansprüche

1. Verfahren zur Herstellung optoelektronischer Bauelemente mit einer Kupferschicht (7) als Trägersubstrat, wobei auf lateralen Flächen (7a) der Kupferschicht (7) eine Schutzschicht (11) angeordnet ist, mit folgenden Schritten:
A) Bereitstellen eines Aufwachssubstrats (1) mit einer darauf angeordneten Halbleiterschicht (2) zur Erzeugung einer im Betrieb aktiven Zone,
B) Aufbringen von Trennstrukturen (6) auf der Halbleiterschicht (2),
C) Aufbringen einer Vielzahl von Kupferschichten (7) auf der Halbleiterschicht (2) in den durch die Trennstrukturen (6) begrenzten Bereichen,
D) Entfernen der Trennstrukturen (6),
E) Aufbringen der Schutzschicht (11) zumindest auf den lateralen Flächen (7a) der Kupferschichten (7),
F) Aufbringen eines Hilfssubstrats (13) auf den Kupferschichten (7),
G) Entfernen des Aufwachssubstrats (1), und
H) Vereinzeln eines Verbunds umfassend die Halbleiterschicht (2), die Kupferschichten (7) und das Hilfssubstrat (13) zu voneinander getrennten Bauelementen,
wobei zur Ausbildung der Schutzschicht (11) eine Metallschicht (8) zumindest auf den lateralen Flächen (7a) aufgebracht wird und die auf den lateralen Flächen (7a) aufgebrachte Metallschicht (8) zu einer Metalloxidschicht oxidiert wird.

2. Verfahren nach dem vorhergehenden Anspruch, wobei die Schutzschicht (11) eine Schicht zur Verhinderung von Kupfer-Migration und eine Lötstoppschicht und eine Leitkleberstoppschicht ist.

3. Verfahren nach einem der vorhergehenden Ansprüche, wobei zwischen den Schritten A) und C) folgender Schritt erfolgt:
I) Aufbringen einer Kontaktschicht (5) auf der Halbleiterschicht (2), und wobei nach Schritt E) folgender Schritt erfolgt:
J) Tempern des Bauelements, so dass die Haftung der Kontaktschicht (5) auf der Kupferschicht (7) verbessert wird.

4. Verfahren nach einem der vorhergehenden Ansprüche, wobei eine weitere Schutzschicht zur Verhinderung einer Oxidation der auf horizontalen Flächen der Kupferschicht (7) angeordneten Metallschicht (8) aufgebracht wird.

5. Verfahren nach einem der vorhergehenden Ansprüche, wobei das Hilfssubstrat (13) durch ein elastisches Substrat (18) ersetzt wird, das nach Durchführung des Vereinzelungs-Schritts zur besseren Weiterbearbeitung der vereinzelten optoelektronischen Bauelemente gedehnt wird.

6. Verfahren nach einem der vorhergehenden Ansprüche, wobei nach Schritt G) folgender Schritt erfolgt:
K1) Aufbringen eines elektrischen Kontaktes (14) auf einem Teilbereich der Oberfläche, die durch Schritt G) freigelegt wurde.

7. Verfahren nach einem der vorhergehenden Ansprüche, wobei nach Schritt G) folgender Schritt erfolgt:
K2) Strukturieren der Halbleiterschicht (2) auf der Oberfläche, die durch Schritt G) freigelegt wurde.

8. Bauelement mit einer Kupferschicht (7) als Trägersubstrat, wobei zumindest auf lateralen Flächen (7a) der Kupferschicht (7) eine Schutzschicht (11) angeordnet ist, wobei
- das Bauelement ein optoelektronisches Bauelement mit einer Halbleiterschicht (2) ist, die auf der Kupferschicht (7) angeordnet ist,
- die gesamte freiliegende Oberfläche der Kupferschicht (7) mit einer horizontalen Fläche und lateralen Flächen (7a) mit einer Metallschicht (8) beschichtet ist, und
- die Schutzschicht (11) die auf den lateralen Flächen (7a) der Kupferschicht (7) aufgebrachte und oxidierte Metallschicht (8) ist, wobei zur Ausbildung der Schutzschicht (11) nur die auf den lateralen Flächen (7a) der Kupferschicht (7) angeordnete Metallschicht (8) oxidiert ist.

9. Optoelektronisches Bauelement nach dem vorhergehenden Anspruch, wobei
die Schutzschicht (11) Nickeloxid enthält.

10. Optoelektronisches Bauelement nach einem der Ansprüche 8 bis 9, wobei
die mindestens eine Halbleiterschicht (2)eine AlGaInP-Schicht und/oder eine AlGaInAs-Schicht umfasst.

11. Optoelektronisches Bauelement nach einem der Ansprüche 8 bis 10, wobei
auf der der Halbleiterschicht zugewandten Hauptseite der Kupferschicht (7) mindestens eine Kontaktschicht (5) angeordnet ist.

12. Optoelektronisches Bauelement nach dem vorhergehenden Anspruch, wobei
die Kontaktschicht (5) ein Lot umfasst, das ausgewählt ist aus einer Gruppe bestehend aus Gold, Palladium, Platin, Zinn, Silber, Nickel und Legierungen dieser Elemente oder aus einem Material dieser Gruppe besteht.

13. Optoelektronisches Bauelement nach einem der Ansprüche 8 bis 12, wobei
auf der der Kupferschicht (7) zugewandten Seite der Halbleiterschicht (2) eine Spiegelschicht (3) angeordnet ist, und
auf der der Kupferschicht (7) zugewandten Seite der Spiegelschicht (3) eine Diffusionsbarriereschicht (4) angeordnet ist.

14. Optoelektronisches Bauelement nach einem der Ansprüche 8 bis 13, wobei
- die Metallschicht (8) die lateralen Flächen (7a) der Kupferschicht (7) vollständig bedeckt, und
- die horizontalen, parallel zur Halbleiterschicht (2) verlaufenden Flächen der Kupferschicht (7) nicht mit der Schutzschicht (11) bedeckt sind.

15. Bauelementanordnung mit mehreren auf einem gemeinsamen Trägerelement (33) angeordneten optoelektronischen Bauelementen (30) nach einem der Ansprüche 8 bis 14, wobei die einzelnen Bauelemente gleich oder verschieden sind und mindestens eines der Bauelemente gemäß Anspruch 10 ausgebildet ist.

## Claims

1. A method for producing optoelectronic components having a copper layer (7) as carrier substrate, wherein a protective layer (11) is arranged on lateral surfaces (7a) of the copper layer (7), having the following steps:
A) providing a growth substrate (1) with a semiconductor layer (2) arranged thereon for producing a zone which is active in operation,
B) applying separation structures (6) to the semiconductor layer (2),
C) applying a plurality of copper layers (7) on the semiconductor layer (2) in the regions bounded by the separation structures (6),
D) removing the separation structures (6),
E) applying the protective layer (11) at least to the lateral surfaces (7a) of the copper layers (7),
F) applying an auxiliary substrate (13) to the copper layers (7),
G) removing the the growth substrate (1), and
H) singulating a composite comprising the semiconductor layer (2), the copper layers (7) and the auxiliary substrate (13) into mutually separate components,
wherein for forming the protective layer (11), a metal layer (8) is applied at least on the lateral surfaces (7a) and the metal layer (8) applied on the lateral surfaces (7a) is oxidized to form a metal oxide layer.

2. The method according to the preceding claim, wherein the protective layer (11) is a layer for the prevention of a copper migration and a soldering stop layer and a conductive adhesive stop layer.

3. The method according to one of the preceding claims, wherein between steps A) and C) the following step is performed:
I) applying a contact layer (5) on the semiconductor layer (2), and wherein following step is carried out after the step E) :
J) annealing the component so as to improve the adhesion of the contact layer (5) to the copper layer (7).

4. The method according to one of the preceding claims, wherein a further protective layer is applied to prevent oxidation of the metal layer (8) arranged on horizontal surfaces of the copper layer (7).

5. The method according to one of the preceding claims, wherein the auxiliary substrate (13) is replaced by an elastic substrate (18) which is stretched after performing the singulation step for a better further processing of the singulated optoelectronic components.

6. The method according to one of the preceding claims, wherein step G) is followed by the following step:
K1) applying an electrical contact (14) on a portion of the surface exposed by step G).

7. The method according to one of the preceding claims, wherein step G) is followed by the following step:
K2) structuring the semiconductor layer (2) at the surface exposed by step G).

8. A component having a copper layer (7) as carrier substrate, wherein a protective layer (11) is arranged at least on lateral surfaces (7a) of the copper layer (7), wherein
- the component is an optoelectronic component having a semiconductor layer (2) arranged on the copper layer (7),
- the entire exposed surface of the copper layer (7) comprising a horizontal surface and lateral surfaces (7a) is coated with a metal layer (8); and
- the protective layer (11) is the metal layer (8) which is applied to the lateral surfaces (7a) of the copper layer (7) and oxidized, wherein for forming the protective layer (11) only the metal layer (8) arranged on the lateral surfaces (7a) of the copper layer (7) is oxidized.

9. The optoelectronic component according to the preceding claim, wherein
the protective layer (11) contains nickel oxide.

10. The optoelectronic component according to any of claims 8 to 9, wherein
the at least one semiconductor layer (2) comprises an AlGaInP layer and/or an AlGaInAs layer.

11. The optoelectronic component according to any of claims 8 to 10, wherein
at least one contact layer (5) is arranged on the main side of the copper layer (7) facing the semiconductor layer.

12. The optoelectronic component according to the preceding claim, wherein
the contact layer (5) comprises a solder which is selected from a group consisting of gold, palladium, platinum, tin, silver, nickel and alloys of these elements or consists of a material of this group.

13. The optoelectronic component according to any of claims 8 to 12, wherein
a mirror layer (3) is arranged on the side of the semiconductor layer (2) facing the copper layer (7), and
a diffusion barrier layer (4) is arranged on the side of the mirror layer (3) facing the copper layer (7).

14. The optoelectronic component according to one of claims 8 to 13, wherein
- the metal layer (8) completely covers the lateral surfaces (7a) of the copper layer (7), and
- the horizontal surfaces of the copper layer (7) running parallel to the semiconductor layer (2) are not covered by the protective layer (11).

15. An arrangement of components having a plurality of optoelectronic components (30) according to one of claims 8 to 14 arranged on a common carrier element (33), wherein the individual components are identical or different and at least one of the components is formed in accordance with claim 10.

## Revendications

1. Procédé de fabrication de composants optoélectroniques comprenant une couche de cuivre (7) comme substrat porteur, une couche de protection (11) étant prévue sur des faces latérales (7a) de la couche de cuivre (7), comportant les étapes suivantes:
A) mise à disposition d'un substrat de croissance (1) avec une couche semi-conductrice (2) agencée sur ce dernier pour générer une zone active pendant le fonctionnement,
B) application de structures de séparation (6) sur la couche semi-conductrice (2),
C) application d'une multitude de couches de cuivre (7) sur la couche semi-conductrice (2) dans les zones délimitées par les structures de séparation (6),
D) élimination des structures de séparation (6),
E) application de la couche de protection (11) sur au moins les faces latérales (7a) des couches de cuivre (7),
F) application d'un substrat auxiliaire (13) sur les couches de cuivre (7),
G) élimination du substrat de croissance (1), et
H) séparation d'un composite comprenant la couche semi-conductrice (2), les couches de cuivre (7) et le substrat auxiliaire (13) pour obtenir des composants individuels, dans lequel une couche métallique (8) est déposée sur au moins les faces latérales (7a) pour constituer la couche de protection (11) et la couche métallique déposée sur les faces latérales (7a) est oxydée pour donner une couche d'oxyde métallique.

2. Procédé selon la revendication précédente, dans lequel la couche de protection (11) est une couche de prévention de migration de cuivre ainsi qu'une couche d'arrêt de brasage et une couche d'arrêt de colle conductrice.

3. Procédé selon l'une des revendications précédentes, dans lequel l'étape suivante est réalisée entre les étapes A) et C) :
I) application d'une couche de contact (5) sur la couche semi-conductrice (2), et dans lequel l'étape suivante est réalisée après l'étape E):
J) trempe du composant de pour améliorer l'adhérence de la couche de contact (5) sur la couche de cuivre (7).

4. Procédé selon l'une des revendications précédentes, dans lequel une couche de protection supplémentaire de prévention d'oxydation de la couche métallique disposée sur des faces horizontales de la couche de cuivre (7) est appliquée.

5. Procédé selon l'une des revendications précédentes, dans lequel le substrat auxiliaire (13) est remplacé par un substrat élastique (18) qui est élongée après réalisation de l'étape de séparation pour permettre un traitement plus aisé des composants optoélectroniques séparés.

6. Procédé selon l'une des revendications précédentes, dans lequel, après l'étape G), l'étape suivante est réalisée:
K1) application d'un contact électrique (14) sur une partie de la surface ayant été dégagée par l'étape G).

7. Procédé selon l'une des revendications précédentes, dans lequel, après l'étape G), l'étape suivante est réalisée:
K2) structuration de la couche semi-conductrice (2) sur la surface ayant été dégagée par l'étape G).

8. Composant optoélectronique comprenant une couche de cuivre (7) comme substrat porteur, une couche de protection (11) étant disposée au moins sur des faces latérales (7a) de la couche de cuivre (7),
dans lequel
- le composant est un composant opto-électronique comportant une couche semi-conductrice (2) disposée sur la couche de cuivre (7),
- la surface entière dégagée de la couche de cuivre (7) comprenant une face horizontale et des faces latérales (7a) est enduite d'une couche métallique (8), et
- la couche de protection (11) est la couche métallique (8) qui est déposée sur les faces latérales (7a) de la couche de cuivre (7) et oxydée, dans lequel pour constituer la couche de protection (11) seule la couche métallique (8) agencée sur les faces latérales (7a) de la couche de cuivre est oxydée.

9. Composant optoélectronique selon la revendication précédente, dans lequel la couche de protection (11) contient de l'oxyde de nickel.

10. Composant optoélectronique selon l'une des revendications 8 à 9, dans lequel l'au moins une couche semi-conductrice (2) comporte une couche AlGaInP et/ou une couche AlGaInAs.

11. Composant optoélectronique selon l'une des revendications 8 à 10, dans lequel au moins une couche de contact (5) est disposée sur la face principale de la couche de cuivre (7) faisant face à la couche semi-conductrice.

12. Composant optoélectronique selon la revendication précédente, dans lequel la couche de contact (5) comprend une brasure choisie dans le groupe comprenant l'or, le palladium, le platine, l'étain, l'argent, le nickel et des alliages desdits éléments ou d'un matériau choisi dans ce groupe.

13. Composant optoélectronique selon l'une des revendications 8 à 12, dans lequel une couche miroir (3) est disposée sur la face de la couche semi-conductrice (2) faisant face à la couche de cuivre (7), et une couche de barrière de diffusion (4) est disposée sur la face de la couche de miroir (3) faisant face à la couche de cuivre (7).

14. Composant optoélectronique selon l'une des revendications 8 à 13, dans lequel
- la couche métallique (8) recouvre entièrement les faces latérales (7a) de la couche de cuivre (7), et
- les faces horizontales de la couche de cuivre (7) s'étendant parallèlement à la couche semi-conductrice (2) sont découvertes de la couche de protection (11).

15. Agencement de composants comportant une pluralité de composants optoélectroniques (30) disposés sur un élément porteur (33) commun selon l'une des revendications 8 à 14, dans lequel les composants individuels sont identiques ou différents et l'un au moins des composants est conçu selon la revendication 10.
